# EUROPEAN PATENT SPECIFICATION

(11) **EP 3 961 633 B1**
(45) Date of publication and mention of the grant of the patent: **01.01.2025**
(21) Application number: 20936097.3
(22) Date of filing: 11.11.2020
(51) Int. Cl.: G01K 7/01, G01K 7/42, G11C 5/04, G11C 5/14, G11C 7/04, G11C 11/4074, G01K 3/00

(54) **SEMICONDUCTOR DEVICE**
HALBLEITERBAUELEMENT
DISPOSITIF À SEMI-CONDUCTEUR

(30) Priority: 30.06.2020 CN 202010611284
(43) Date of publication of application: 02.03.2022
(73) Proprietor: Changxin Memory Technologies, Inc., Hefei City, Anhui 230601 (CN)
(72) Inventor: NING, Shuliang, Hefei City, Anhui 230601 (CN)
(74) Representative: Lavoix
(86) International application number: PCT/CN2020/128132
(87) International publication number: WO 2022/000926

(56) References cited:
- CN-A- 1 283 853
- CN-A- 102 543 941
- CN-A- 104 115 227
- CN-A- 105 390 481
- CN-U- 206 559 408
- CN-U- 211 507 637
- CN-U- 212 303 077
- CN-U- 212 303 078
- CN-U- 212 303 079
- US-A1- 2001 026 576
- US-A1- 2006 221 741
- US-A1- 2008 106 928
- US-A1- 2010 169 551
- US-A1- 2016 064 063
- US-A1- 2017 227 405

## Description

This application is a continuation application of International Patent Application No. PCT/CN2020/128132, which claims priority to Chinese Patent Application No. 202010611284.3, filed with the Chinese Patent Office on June 30,2020 and entitled " SEMICONDUCTOR DEVICE".

### TECHNICAL FILED

The present invention relates to the field of memory, in particular to a semiconductor device.

### BACKGROUND OF THE INVENTION

Dynamic Random Access Memory (DRAM) is a semiconductor storage device commonly used in computers, and its storage array region consists of many repeating storage cells. Each of the storage cells typically includes a capacitor and a transistor, wherein the gate of the transistor is connected to a word line, the drain is connected to a bit line, and the source electrode is connected to the capacitor. The voltage signal over the word line can control ON/OFF of the transistor, and then data information stored in the capacitor is read through the bit line, or data information is written through the bit line to the capacitor for storage. The US 2001/026576 A1 discloses a method for determining the temperature of a semiconductor chip and semiconductor chip with temperature measuring configuration. The US patent document US 2008/106928 A1 discloses an energy adjusted write pulses in phase-change memory cells. The US patent document US 2017/227405 A1 discloses a thermal event sensor.

Temperature has a great effect on memory write. In low temperature environments, in the case of writing to memory, there are problems of long writing time and low writing stability.

### SUMMARY

The technical problem to be solved by the present invention is to provide a semiconductor device that enables the activation of a temperature detection unit to be free from whether a storage chip is activated such that the detection of the temperature of the storage chip is not affected by whether a storage chip is activated.

In order to solve the above problem, the present invention provides a semiconductor device according to claim 1. The dependent claims set out particular embodiments of the invention.

The present invention has the following advantages. The storage chip and the temperature detection unit use different power supplies, and thus, the activations of both of them can be controlled separately, i.e., the activation of the temperature detection unit is free from whether a storage chip is activated, so that the detection of the temperature of the storage chip is free from whether a storage chip is activated, thereby providing a reference for the activation and operation of the storage chip, and in turn avoiding the activation or operation of the storage chip under low temperatures and improving the stability of the storage chip.

### BRIEF DESCRIPTION OF THE DRAWINGS

Figure 1 is a schematic structural diagram of a first embodiment of a semiconductor device according to the present invention;
Figure 2 is a schematic circuit diagram of the first embodiment of the semiconductor device according to the present invention;
Figure 3 is a timing diagram of supplying power to the temperature detection unit 110 and the storage chip 100;
Figure 4 is a schematic structural diagram of a second embodiment of the semiconductor device according to the present invention;
Figure 5 is a schematic structural diagram of a third embodiment of the semiconductor device according to the present invention; and
Figure 6 is a schematic structural diagram of a fourth embodiment of the semiconductor device according to the present invention.

### DESCRIPTION OF THE EMBODIMENTS

Embodiments of the semiconductor device according to the present invention are detailed below in combination with drawings.

As described in the background of the invention, temperature has a great effect on memory write, and in low temperature environments, in the case of writing to memory, there are problems of long writing time and low writing stability.

Studies find out that, when existing memory operates in low temperature environments, the stability of memory write is affected since a temperature drop may cause increased resistances of the word line, bit line, metal connecting line (metal contacting portion), or the like in the memory, and the increased resistances may cause varied or extended time when data is written into memory.

Therefore, the present invention provides a semiconductor device with a temperature detection unit to detect the temperature of the storage chip so as to provide a reference for the activation and operation of the storage chip, thereby avoiding the activation and operation of the storage chip under low temperatures, shortening write time, and improving the stability of the storage chip write.

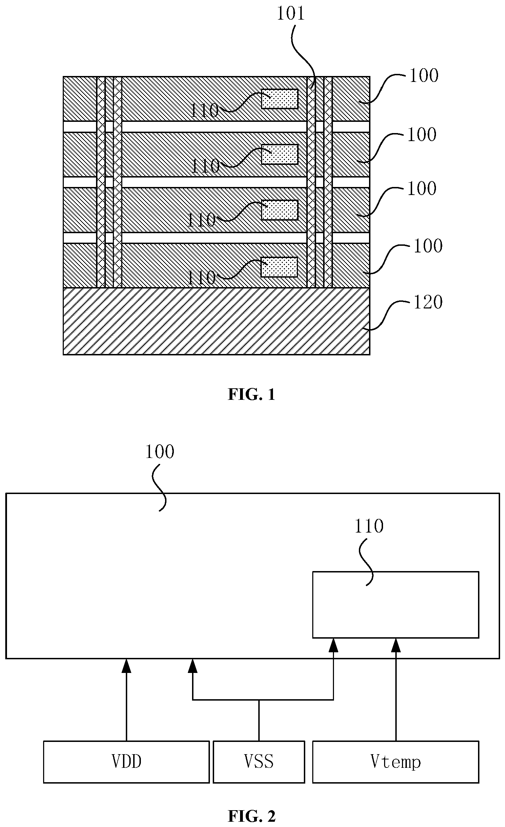

Figure 1 is a schematic structural diagram of the first embodiment of the semiconductor device according to the present invention. Referring to Figure 1, the semiconductor device according to the present invention includes a storage chip 100 and a temperature detection unit 110.

The storage chip 100 is an existing memory capable of performing data write, data read, and/or data deletion. The storage chip 100 is formed by the semiconductor integration fabricating process. Specifically, the storage chip 100 can include a storage array and peripheral circuits connected to the storage array. The storage array includes a plurality of storage cells and bit lines, word lines, and metal connecting lines (metal contacting portions) that are connected to the storage cells. The storage cells are configured to store data, and the peripheral circuits are related circuits when operations are performed on the storage arrays. In the present embodiment, the storage chip 100 is a DRAM storage chip, which includes a plurality of storage cells. The storage cell includes a capacitor and a transistor. The gate of the transistor is connected to a word line, the drain is connected to a bit line, and the source electrode is connected to the capacitor. In other embodiments, as the storage chip 100, other types of storage chips may be used.

The temperature detection unit 110 is configured to detect the temperature of the storage chip 100. The temperature detection unit 110 includes a temperature sensor for sensing a temperature and converting the sensed temperature to an electric signal. The temperature sensor may be a PN junction diode temperature sensor or a capacitive temperature sensor.

The semiconductor device includes one or more storage chips 100 and one or more temperature detection units 110. The temperature detection unit 110 may be configured to detect the temperature(s) of one or more storage chips 100. The temperature detection unit 110 may be in one-to-one relationship or one-to-many relationship with the storage chip 100.

When the number of the storage chip 100 is one, and the number of the temperature detection unit 110 is also one, the temperature detection unit 110 is in one-to-one relationship with the storage chip 100 and configured to merely detect the temperature of this storage chip 100.

When the number of the storage chip 100 is more than one, and the number of the temperature detection unit 110 is one, the temperature detection unit 110 is in one-to-many relationship with the storage chip 100 and configured to detect the temperatures of the more than one storage chips 100.

When the number of the storage chip 100 is more than one, and the number of the temperature detection unit 110 is also more than one, but the number of the temperature detection unit 110 is less than the number of the storage chip 100, the temperature detection unit 110 and the storage chip 100 may have one-to-one relationship and one-to-many relationship simultaneously, or have one-to-many relationship only. That is, there may be the situation where one of the temperature detection units 110 detects one storage chip 100 only and one temperature detection unit 110 detects more than one of the storage chips 100, or only the situation where one temperature detection unit 110 detects more than one of the storage chips 100.

When the number of the storage chip 100 is more than one, the number of the temperature detection unit 110 is also more than one, and the number of the temperature detection unit 110 equals to the number of the storage chip 100, the temperature detection unit 110 is in one-to-one relationship with the storage chip 100, and one temperature detection unit 110 is configured to detect the temperature of one of the storage chips 100.

In the present embodiment, the semiconductor device includes a plurality of storage chips 100 disposed as a stack and a plurality of temperature detection unit 110 one-to-one corresponding to the storage chips 100. Four storage chips 100 and four temperature detection units 110 are schematically depicted in Figure 1.

The temperature detection units 110 and the storage chips 100 are powered by different power supplies. Figure 2 is a schematic diagram of the circuit connections of the first embodiment of the semiconductor device according to the present invention. Referring to Figure 2, the temperature detection unit 110 is powered by a power supply Vtemp, and the storage chip 100 is powered by VDD. Since the temperature detection unit 110 and the storage chip 100 are powered by different power supplies, the power supplied to the temperature detection unit 110 and the power supplied to the storage chip 100 can be controlled independently, thereby enabling the temperature detection unit 110 to be activated at a different time from the storage chip 100.

As described above, temperature has a great influence on the performance of the storage chip 100, especially when the storage chip 100 is activated. If the storage chip 100 is activated under low temperatures, the time of writing data into the storage chip 100 may vary or extend, affecting the stability of the storage chip 100. Therefore, the temperature of the storage chip is required to be measured before the activation of the storage chip 100 such that the storage chip 100 can be activated within a suitable temperature.

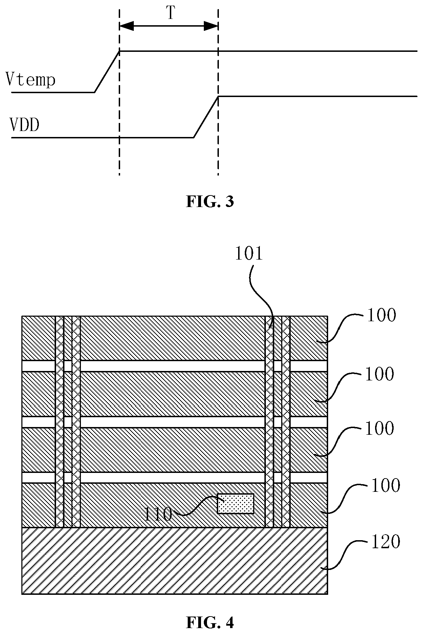

Therefore, in the present invention, the power supplied to the temperature detection unit 110 is earlier than the power supplied to the storage chip 100, i.e., before the storage chip 100 is activated, the temperature detection unit 110 has been activated, and thus, the temperature prior to the activation of the storage chip 100 can be acquired so as to provide a reference for the activation of the storage chip 100. Figure 3 is a timing diagram of supplying power to the temperature detection unit 110 and the storage chip 100. Referring to Figure 3, after power is supplied to the temperature detection unit 110 for time T, power is supplied to the storage chip 100. The time may be a preset time, or the time taken by the temperature of the storage chip 100 to reach a set threshold temperature.

Further, referring to Figure 2, the temperature detection unit 110 and the storage chip 100 share the same grounding terminal VSS. The advantage thereof is as follows. On one hand, the leakage current of the non-activated phase of the storage chip 100 will not increase, and on the other hand, the number of the pins will reduce, thereby saving space.

In the present embodiment, the semiconductor device further includes a control chip 120. The storage chip 100 and the temperature detection unit 110 are electrically connected to the control chip 120. The control chip 120 is configured to control the activation and operation of the storage chip 100 and the temperature detection unit 110. The grounding terminal VSS, the power supply VDD and the power supply Vtemp are provided by the control chip 120. The activation of the storage chip 100 includes power up and self-check, and the operation of the storage chip 100 includes writing data to the storage chip 100, reading data from the storage chip 100, and deleting the accessed data in the storage chip 100, or the like. A plurality of storage chips 100 are stacked on the control chip 120, which bonds with the storage chip 100 at the bottommost layer of the stack structure. However, in another embodiment of the present invention, when only one storage chip 100 is provided, this storage chip 100 is disposed on and bonds with the control chip 120.

The storage chip 100 has a through-silicon-via interconnecting structure 101 formed therein. With the through-silicon-via interconnecting structure 101, the storage chip 100 is electrically connected to the control chip 120, and the temperature detection unit 110 is electrically connected to the control chip 120. That is, with the through-silicon-via interconnecting structure 101, the storage chip 100 is electrically connected to the grounding terminal VSS and the power supply VDD, and the temperature detection unit 110 is electrically connected to the power supply Vtemp and the grounding terminal VSS. Specifically, in the present embodiment, when the plurality of the storage chips 100 are stacked, each of the storage chips 100 may be connected to the control chip 120 through different through-silicon-via interconnecting structures; when a plurality of the temperature detection units 110 is provided, there may be the situation where each of the temperature detection units 110 is connected to the control chip 120 through through-silicon-via interconnecting structures, and also the situation where the plurality of the temperature detection units 110 share the through-silicon-via interconnecting structure so as to connect to the control chip 120. It can be understood that the storage chip 100 and the temperature detection units 110 are connected to the control chip 120 through different through-silicon-via interconnecting structures such that the temperature detection units 110 and the storage chip 100 can be powered by different power supplies. Further, the power supplying of the plurality of the temperature detection units 110 may also share the technology of through-silicon-via interconnecting structure.

In other embodiments, the storage chip 100 and the temperature detection unit may also electrically connect to the control chip 120 by metal leads (formed by the lead bonding process).

Further, the temperature detection unit 110 may be formed in the storage chip 100 by the semiconductor integration fabricating process. In the case of merely detecting the temperature of one storage chip 100, the temperature detection unit 110 may be formed in this storage chip 100. For example, in the present embodiment, as shown in Figure 1, the temperature detection units 110 are one-to-one corresponding to the storage chips 100, and each storage chip 100 is provided with one temperature detection unit 110 therein. In the case of detecting the temperatures of a plurality of the storage chips 100, the temperature detection unit 110 may be formed in any one of the plurality of the storage chips 100 or in the storage chip 100 at the centered or bottommost layer. For example, in the second embodiment of the present invention, referring to Figure 4 which is a schematic structural diagram of the second embodiment of the semiconductor device according to the present invention, the temperature detection unit 110 is disposed in the storage chip 100 at the bottommost layer and capable of measuring the temperatures of four storage chips 100.

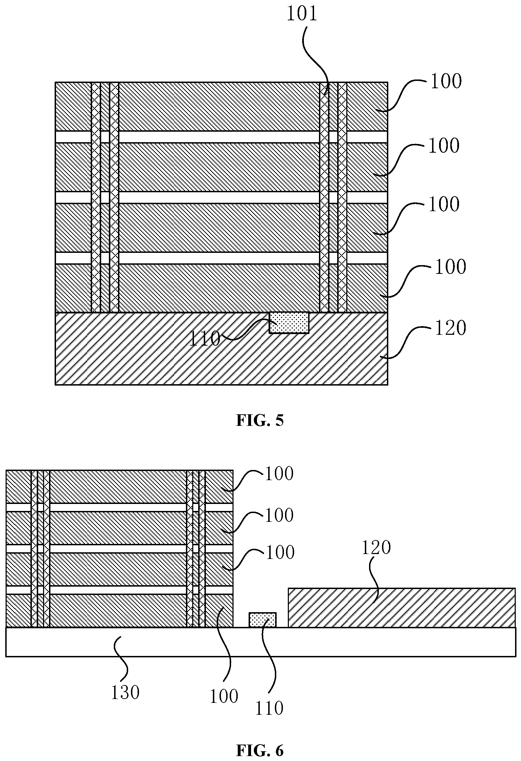

In another embodiment of the present invention, the temperature detection unit 110 is disposed in the control chip 120 rather than a storage chip 100. Specifically, referring to Figure 5 which is a schematic structural diagram of the third embodiment of the semiconductor device according to the present invention, the temperature detection unit 110 is disposed in the control chip 120 and capable of measuring the temperatures of four storage chips 100 stacked on the control chip 120.

In another embodiment of the present invention, referring to Figure 6 which is a schematic structural diagram of the fourth embodiment of the semiconductor device according to the present invention, the semiconductor device further includes a wiring substrate 130 having connection lines (not depicted in the drawing) provided therein, wherein both of the storage chip 100 and the control chip 120 are located on the wiring substrate 130, and the storage chip 100 and the control chip 120 are electrically connected through the connection lines in the wiring substrate 130. In this embodiment, the temperature detection unit 110 is also disposed on the wiring substrate 130 and configured to measure the ambient temperature. This ambient temperature is close to the temperature of the storage chip 100 and may be approximately as the temperature of the storage chip 100. The wiring substrate 130 includes, but not limited to, a PCB circuit board. It can be understood that, in other embodiments of the present invention, the temperature detection unit 110 may not be disposed on the wiring substrate 130, and is disposed in the storage chip 100 or the control chip 120, as shown in Figures 1, 4 and 5.

In the semiconductor device according to the present invention, the storage chip and the temperature detection unit use different power supplies, and thus, the activations of both of them can be controlled separately, i.e., the activation of the temperature detection unit is free from whether a storage chip is activated, so that the detection of the temperature of the storage chip is free from whether a storage chip is activated, thereby providing a reference for the activation and operation of the storage chip, and in turn avoiding the activation or operation of the storage chip under low temperatures and improving the stability of the storage chip.

When the storage chip 100 is in a low temperature environment, if the storage chip 100 is heated, then the temperature thereof increases quickly, thereby expediting the activation of the storage chip 100. Therefore, the control chip 120 according to the present invention can further be activated prior to the activation of the storage chip 100, and the control chip 120 heats the storage chip 100 by heat generated itself after activation so as to raise the temperature of the storage chip 100 quickly.

After being activated, the control chip 120 controls the activation of the temperature detection unit 110 so as to detect the temperature of the storage chip 100. The temperature detection unit 110 can further transmit the detected temperature to the control chip 120 as the data of the control chip 120.

The control chip 120 can judge whether a temperature detected by the temperature detection unit 110 reaches a set threshold, and control the activation of the storage chip 100 if the set threshold is reached. The control chip can control the activation of the storage chip by supplying power to the storage chip.

If only one temperature detection unit 110 and one storage chip 100 are provided, and the one temperature detection unit 110 is configured to merely detect the temperature of one storage chip 100, when the control chip 120 judges that the temperature detected by this temperature detection unit 110 reaches a set threshold, then the control chip 120 controls the activation of this storage chip 100.

If one temperature detection unit 110 and a plurality of storage chips 100 are provided, and the one temperature detection unit 110 is configured to detect the temperatures of the plurality of storage chips 100, when the control chip 120 judges that the temperature detected by this temperature detection unit 110 reaches a set threshold, then the control chip 120 first controls the activation of the storage chip 100 closest to the control chip 120, and then controls the subsequent activations of other storage chips 100 above.

If a plurality of temperature detection units 110 and a plurality of storage chips 100 are provided, there may be the situation where one of the temperature detection units 110 merely detects one storage chip 100 and one temperature detection unit 110 detects a plurality of the storage chips 100, or only the situation where one temperature detection unit 110 detects a plurality of the storage chips 100. When the control chip 120 judges that the temperature detected by a certain temperature detection unit 110 reaches a set threshold, the control chip 120 controls the activation of the storage chip 100 corresponding to this temperature detection unit 110, and if this temperature detection unit 110 detects the temperatures of a plurality of the storage chips 100, then the control chip 120 first controls the activation of the storage chip 100 closest to the control chip 120, and then controls the subsequent activations of other storage chips 100 above.

If a plurality of temperature detection units 110 and a plurality of storage chips 100 are provided, and the plurality of temperature detection units 110 are one-to-one corresponding to the plurality of storage chips 100, when the control chip 120 judges that the temperature detected by a certain temperature detection unit 110 reaches a set threshold, the control chip 120 controls the activation of the storage chip 100 corresponding to this temperature detection unit 110. Specifically, there are four storage chips 100 in the stack structure as shown in Figure 1, each of the storage chips 100 has one temperature detection unit 110 correspondingly, and thus, each of the temperature detection units 110 detects the temperature of the corresponding storage chip 100, obtaining four detection values of temperature. The control chip 120 sequentially judges whether the temperatures detected by the four of the temperature detection units 110 reach a set threshold, and if a temperature detected by a certain temperature detection unit 110 reaches the set threshold, then the control chip 120 controls the activation of the storage chip corresponding to this temperature detection unit 110. For example, if the temperature detected by the temperature detection unit 110 in the storage chip 100 at the bottommost layer of the stack structure first reaches the set threshold, then the control chip 120 first controls the activation of the storage chip 100 at the bottommost layer of the stack structure; next, if the temperature detected by the corresponding temperature detection unit 110 in the storage chip 100 at the last but one layer of the stack structure also reaches the set threshold, the control chip 120 then controls the activation of the storage chip 100 at the last but one layer of the stack structure; the activation of the storage chips 100 at the two layers above are performed similarly.

For the semiconductor device having a plurality of storage chips 100, such aforementioned control structure and control manner further improve the precision of the activation timing of each storage chip 100, further shorten the write time when data is written to each storage chip 100 in a low temperature environment, and further improves the stability of writing to each storage chip 100.

When the semiconductor device according to the present invention operates in a low temperature environment, the temperature of the storage chip 100 can be raised to the set threshold by the control chip 120, preventing the increased resistances of the word line, bit line and metal connecting line (metal contacting portion) in the storage chip 100 due to the excessive low ambient temperature, thereby shortening the write time when data is written into the storage chip in a low temperature environment and improving the stability of writing to the storage chip. The set threshold may be set in the control chip 120, and the specific magnitude of the set threshold may be set as needed or based on experience.

In another embodiment, the control chip 120 may have an additional heating circuit (not depicted in the drawing) provided therein. The heating circuit is configured to heat the storage chip 100. Before or after the control chip 120 heats the storage chip 100, the control chip 120 judges whether a temperature of the storage chip 100 detected by the temperature detection unit 110 reaches a set threshold. If the set threshold is not reached, then the control chip controls the heating circuit to heat the storage chip 100; and if the set threshold is reached, then the control chip controls the heating circuit to stop heating the storage chip 100. Therefore, the accurate control of the heating process is realized such that the temperature of the storage chip 100 can be kept around the set threshold, preventing the excessive high or excessive low temperature of the storage chip 100, and thus, the write time to memory is always short.

## Claims

1. A semiconductor device, comprising a storage chip (100), a temperature detection unit, a control chip (120), a first power supply (Vtemp), and a second power supply (VDD),
wherein the temperature detection unit (110) is configured to detect the temperature of the storage chip (100), and the control chip (120) is configured to heat the storage chip prior to the activation of the storage chip; wherein the temperature detection unit (110) being powered by the first power supply (Vtemp), and the storage chip (100) being powered by the second power supply (VDD); and
wherein the semiconductor device is configured to supply power to the temperature detection unit before supplying power to the storage chip (100).

2. The semiconductor device according to claim 1, wherein the temperature detection unit (110) is disposed in the storage chip (100).

3. The semiconductor device according to claim 2, wherein the temperature detection unit (110) and the storage chip (100) share the same grounding terminal.

4. The semiconductor device according to claim 2, wherein one or more storage chips (100) are provided, and in the case of a plurality of the storage chips (100), the plurality of the storage chips (100) is sequentially stacked upwardly.

5. The semiconductor device according to claim 4, wherein in the case of a plurality of the storage chips (100), the storage chips (100) are electrically connected to the grounding terminal (VSS) and the second power supply (VDD) with a through-silicon-via interconnecting structure.

6. The semiconductor device according to claim 4, wherein one or more temperature detection units (110) are provided.

7. The semiconductor device according to claim 6, wherein the temperature detection unit (110) is one-to-one corresponding to the storage chip (100).

8. The semiconductor device according to claim 2, wherein the storage chip (100) and the temperature detection unit (110) are electrically connected to the control chip (120).

9. The semiconductor device according to claim 8, wherein the control chip (120) is configured to judge whether a temperature detected by the temperature detection unit (110) reaches a set threshold, and to control the activation of the storage chip (100) if the set threshold is reached.

10. The semiconductor device according to claim 9, wherein the control chip supplies power to the storage chip (100) so as to control the activation of the storage chip (100).

11. The semiconductor device according to claim 9, wherein the control chip (120) is activated before the activation of the storage chip (100), and the control chip (120) generates heat by itself after activation so as to heat the storage chip.

12. The semiconductor device according to claim 11, wherein after being activated, the control chip (120) controls the activation of the temperature detection unit (110).

13. The semiconductor device according to claim 9, wherein the control chip (120) has an additional heating circuit provided therein for heating the storage chip.

14. The semiconductor device according to claim 13, wherein before or after the control chip (120) heats the storage chip (100), the control chip judges whether a temperature of the storage chip (100) detected by the temperature detection unit (110) reaches a set threshold; if the set threshold is not reached, then the control chip (120) controls the heating circuit to heat the storage chip (100); and if the set threshold is reached, then the control chip (120) controls the heating circuit to stop heating the storage chip (100).

## Patentansprüche

1. Halbleitervorrichtung, umfassend einen Speicherchip (100), eine Temperaturerfassungseinheit, einen Steuerchip (120), eine erste Stromversorgung (Vtemp) und eine zweite Stromversorgung (VDD), wobei die Temperaturerfassungseinheit (110) so konfiguriert ist, dass sie die Temperatur des Speicherchips (100) erfasst, und der Steuerchip (120) so konfiguriert ist, dass er den Speicherchip vor der Aktivierung des Speicherchips aufheizt; wobei die Temperaturerfassungseinheit (110) von der ersten
Stromversorgung (Vtemp) mit Strom versorgt wird und der Speicherchip (100) von der zweiten Stromversorgung (VDD) mit Strom versorgt wird; und
wobei die Halbleitervorrichtung so konfiguriert ist, dass sie die Temperaturerfassungseinheit mit Strom versorgt, bevor sie den Speicherchip (100) mit Strom versorgt.

2. Halbleitervorrichtung nach Anspruch 1, wobei die Temperaturerfassungseinheit (110) in dem Speicherchip (100) angeordnet ist.

3. Halbleitervorrichtung nach Anspruch 2, wobei die Temperaturerfassungseinheit (110) und der Speicherchip (100) denselben Erdungsanschluss haben.

4. Halbleitervorrichtung nach Anspruch 2, wobei mindestens ein Speicherchip (100) vorgesehen ist, und im Falle einer Vielzahl von Speicherchips (100) die Vielzahl von Speicherchips (100) nacheinander aufwärts gestapelt ist.

5. Halbleitervorrichtung nach Anspruch 4, wobei im Falle einer Vielzahl von Speicherchips (100) die Speicherchips (100) mit dem Erdungsanschluss (VSS) und der zweiten Stromversorgung (VDD) über eine Durchkontaktierungsstruktur aus Silizium elektrisch verbunden sind.

6. Halbleitervorrichtung nach Anspruch 4, wobei mindestens eine Temperaturerfassungseinheit (110) vorgesehen ist.

7. Halbleitervorrichtung nach Anspruch 6, wobei die Temperaturerfassungseinheit (110) dem Speicherchip (100) eins zu eins entspricht.

8. Halbleitervorrichtung nach Anspruch 2, wobei der Speicherchip (100) und die Temperaturerfassungseinheit (110) elektrisch mit dem Steuerchip (120) verbunden sind.

9. Halbleitervorrichtung nach Anspruch 8, wobei der Steuerchip (120) so konfiguriert ist, dass er beurteilt, ob eine von der Temperaturerfassungseinheit (110) erfasste Temperatur einen eingestellten Schwellenwert erreicht, und die Aktivierung des Speicherchips (100) steuert, wenn der eingestellte Schwellenwert erreicht ist.

10. Halbleitervorrichtung nach Anspruch 9, wobei der Steuerchip den Speicherchip (100) mit Strom versorgt, um die Aktivierung des Speicherchips (100) zu steuern.

11. Halbleitervorrichtung nach Anspruch 9, wobei der Steuerchip (120) vor der Aktivierung des Speicherchips (100) aktiviert wird und der Steuerchip (120) nach der Aktivierung selbst Wärme erzeugt, um den Speicherchip zu erwärmen.

12. Halbleitervorrichtung nach Anspruch 11, wobei, nach der Aktivierung, der Steuerchip (120) die Aktivierung der Temperaturerfassungseinheit (110) steuert.

13. Halbleitervorrichtung nach Anspruch 9, wobei der Steuerchip (120) eine zusätzliche Heizschaltung zum Aufheizen des Speicherchips aufweist.

14. Halbleitervorrichtung nach Anspruch 13, wobei, vor oder nach dem Aufheizen des Speicherchips (100), der Steuerchip (120) beurteilt, ob eine von der Temperaturerfassungseinheit (110) erfasste Temperatur des Speicherchips (100) einen eingestellten Schwellenwert erreicht; wenn der eingestellte Schwellenwert nicht erreicht wird, dann steuert der Steuerchip (120) die Heizschaltung, um den Speicherchip (100) aufzuheizen; und wenn der eingestellte Schwellenwert erreicht wird, dann steuert der Steuerchip (120) die Heizschaltung, um das Aufheizen des Speicherchips (100) zu beenden.

## Revendications

1. Dispositif à semi-conducteur comprenant une puce de stockage (100), une unité de détection de la température, une puce de commande (120), une première alimentation (Vtemp) et une seconde alimentation (VDD), dans lequel l'unité de détection de la température (110) est configurée pour détecter la température de la puce de stockage (100), et la puce de commande (120) est configurée pour chauffer la puce de stockage avant l'activation de la puce de stockage ; dans lequel l'unité de détection de température (110) est alimentée par la première
alimentation (Vtemp), et la puce de stockage (100) est alimentée par la seconde source d'alimentation (VDD) ; et
dans lequel le dispositif à semi-conducteur est configuré pour alimenter l'unité de détection de la température avant d'alimenter la puce de stockage (100).

2. Dispositif à semi-conducteur selon la revendication 1, dans lequel l'unité de détection de la température (110) est disposée dans la puce de stockage (100).

3. Dispositif à semi-conducteur selon la revendication 2, dans lequel l'unité de détection de la température (110) et la puce de stockage (100) partagent la même borne de mise à la terre.

4. Dispositif à semi-conducteur selon la revendication 2, dans lequel une ou plusieurs puces de stockage (100) sont fournies, et dans le cas d'une pluralité de puces de stockage (100), la pluralité de puces de stockage (100) est empilée successivement vers le haut.

5. Dispositif à semi-conducteur selon la revendication 4, dans lequel, dans le cas d'une pluralité de puces de stockage (100), les puces de stockage (100) sont électriquement connectées à la borne de mise à la terre (VSS) et à la seconde alimentation (VDD) avec une structure d'interconnexion verticale.

6. Dispositif à semi-conducteur selon la revendication 4, dans lequel une ou plusieurs unités de détection de la température (110) sont fournies.

7. Dispositif à semi-conducteur selon la revendication 6, dans lequel l'unité de détection de la température (110) présente une correspondance biunivoque avec la puce de stockage (100).

8. Dispositif à semi-conducteur selon la revendication 2, dans lequel la puce de stockage (100) et l'unité de détection de la température (110) sont connectées électriquement à la puce de commande (120).

9. Dispositif à semi-conducteur selon la revendication 8, dans lequel la puce de commande (120) est configurée pour juger si une température détectée par l'unité de détection de la température (110) atteint un seuil défini, et pour commander l'activation de la puce de stockage (100) si le seuil défini est atteint.

10. Dispositif à semi-conducteur selon la revendication 9, dans lequel la puce de commande alimente la puce de stockage (100) de manière à commander l'activation de la puce de stockage (100).

11. Dispositif à semi-conducteur selon la revendication 9, dans lequel la puce de commande (120) est activée avant l'activation de la puce de stockage (100), et la puce de commande (120) génère elle-même de la chaleur après l'activation de manière à chauffer la puce de stockage.

12. Dispositif à semi-conducteur selon la revendication 11, dans lequel, après avoir été activée, la puce de commande (120) commande l'activation de l'unité de détection de la température (110).

13. Dispositif à semi-conducteur selon la revendication 9, dans lequel la puce de commande (120) comporte un circuit de chauffage supplémentaire pour chauffer la puce de stockage.

14. Dispositif à semi-conducteur selon la revendication 13, dans lequel avant ou après que la puce de commande (120) chauffe la puce de stockage (100), la puce de commande juge si une température de la puce de stockage (100) détectée par l'unité de détection de la température (110) atteint un seuil défini ; si le seuil défini n'est pas atteint, la puce de commande (120) commande alors le circuit de chauffage pour chauffer la puce de stockage (100) ; et si le seuil défini est atteint, la puce de commande (120) commande alors le circuit de chauffage pour arrêter de chauffer la puce de stockage (100).
